# EUROPEAN PATENT APPLICATION

(11) **EP 4 474 921 A1**
(43) Date of publication of application: **11.12.2024**
(21) Application number: 23178271.5
(22) Date of filing: 08.06.2023
(51) Int. Cl.: G04B 17/04, G04B 17/22, G04B 15/14, G04B 13/02, B81C 1/00, G04B 17/28

(54) **COMPONENT, SUCH AS AN OSCILLATOR, FOR A MOVEMENT FOR A WATCH**

(71) Applicant: Flexous Mechanisms IP B.V., 2629 JD Delft (NL)
(72) Inventor: JOVIC, Aleksandar, 2629 JD Delft (NL); MAK, Robin, 2629 JD Delft (NL)
(74) Representative: De Vries & Metman

(57) **Abstract**

The invention relates to a component, such as an oscillator (1), for a movement for a watch, made from a brittle material and comprising a layer (11) covering at least part of the component (1). The layer (11) exerts a stress on the brittle material it covers and at least part of the layer (11) is covered with a further layer (12) that exerts an opposite stress.

## Description

The invention relates to a component, such as an oscillator, for a movement for a watch, in particular a wristwatch, which component is made from a brittle material, such as silicon, and comprises a layer covering at least part of the component, in particular at least part of the surface of the brittle material. The invention further relates to a method of adjusting a mechanical watch and to a mechanical watch, in particular a wrist watch, comprising the mentioned component.

NL 2024076 relates to a mechanical watch comprising an oscillator embodied with a vibratory mass or masses, wherein each vibratory mass connects to at least one flexural member. The watch further comprises an escape wheel and anchor teeth that are connected to the vibratory mass or masses, which anchor teeth cooperate with the escape wheel, and wherein the anchor teeth are provided on at least one of the flexural members of the oscillator.

CH 708 067 relates to a hairspring (reference sign 1 in the drawings of CH 708 067) intended to equip a balance-and-hairspring mechanical oscillator of a watch movement or other precision instrument, and comprising a silicon bar (2) comprising an outer surface (3), and having a first thermal coefficient of the module de Young (CTE). The spiral spring (1) further comprises material for at least partially compensating the first CTE of the silicon and characterized in that the material is added either in the form of a coating (4, 8) comprising a metal or an alloy and covering at least partially the outer surface (3) of the spiral spring (1); or inside the silicon outer surface (3) of the spiral spring (1).

Since silicon is a brittle material, a thin film coating is usually applied to improve wear resistance and/or prevent scratches or other damage.

It is an object of the present invention to improve watch components, in particular to reduce temperature sensitivity.

To this end, the mentioned layer exerts a stress, e.g. a tensile stress or a compressive stress, on the brittle material it covers and at least part of the (first) layer is covered with a further layer that exerts an opposite stress, i.e. a compressive stress if the first layer exerts a tensile stress or a tensile stress if the first layer exerts a compressive stress, e.g. on the first layer.

In an embodiment, the resultant stress of the layers of opposite stress is less than 10%, preferably less than 5%, preferably less than 2%, of the stress exerted by the first layer alone.

In an embodiment, the thickness of the layers is in a range from 30 nanometers (nm) to 20 micrometers (pm), preferably in a range from 50 nm to 10 µm.

The stress reduction achieved with the present invention improves the reliability of horological parts made of a brittle material, in particular silicon, in that it can be employed to reduce stress concentration, occurring in the sharp edges of horological parts, reducing the risk chipping off. Also, the present invention provides additional options for improving time keeping, e.g. by reducing orientation dependence and temperature sensitivity of watch movements, as will be explained in more detail below.

In an embodiment, examples of the material forming a layer exerting a compressive stress include silicon oxide, in particular SiO₂, silicon nitride, aluminium nitride, titanium nitride, diamond, and polysilicon. Examples of the material forming a layer exerting tensile stress include silicon nitride, silicon carbide, aluminium nitride, aluminium oxide, e.g. AL₂O₃, aluminium, and polysilicon.

In an embodiment, the tensile or compressive stress exerted by the layers is in a range from 50 MegaPascal (MPa) to 2 GigaPascal (GPa), preferably 100 to 1.5 GPa.

Layers can be deposited by known methods, such as thermal growth, any type of epitaxial growth, any type of chemical vapour deposition (CVD), including low pressure CVD and plasma enhanced CVD, atomic layer deposition, physical vapor deposition, including sputtering and evaporation.

Thermally grown silicon dioxide typically provides layers having a compressive stress in a range from -300 to - 400 MPa (deposition at lower temperatures results in a lower stress in the grown layer; the minus denotes compressive stress), whereas silicon nitride provides layers having a stress in a range from -3 Gpa (compressive) to 1.5 GPa (tensile), depending on process parameters, such as nitrogen contend, power (of the plasma), temperature, and pressure.

The Handbook of Silicon Based MEMS Materials and Technologies, A volume in Micro and Nano Technologies Book, 2nd Edition, Kuo-Shen Chen and Kuang-Shun Ou, "MEMS Residual Stress Characterization: Methodology and Perspective" contains suitable methods of measuring stress in thin deposited layers, notably the method explained in section 17.2.1 (this latter defines layer thickness within the framework of the present invention).

In an embodiment, the (total) thickness of the compressive layer(s) multiplied by the compressive stress exerted by this layer or these layers is at least substantially equal to, e.g. differs less than 10%, preferably less than 5%, preferably less than 2% from the (total) thickness of the tensile layer(s) multiplied by the tensile stress.

In an embodiment, the component comprises one or more parts, in particular flexures, having, in cross-section, one or more inclined walls, e.g. walls inclined relative to the main (imaginary) plane in which the component extends, and wherein at least one of the parts is provided with the first and further layers.

More specifically, in the case of an oscillator, e.g. including at least one mass and one or more flexures suspending the mass from a ground, stress reduction in accordance with the present invention can be used to reduce warping of in particular the flexure(s) and thus to reduce variations in the frequency of the oscillator between different positions due to gravity. Reference positions include traditionally HH (the watch lies flat, watch dial facing up), 12H (nr 12 on the watch dial is up), 3H (nr 3 on the watch dial is up), 6H (nr 6 up), 9H (nr 9 up), HB (watch lies flat, dial facing down) and in most watches the oscillator extends in a plane parallel to the watch dial (as well as parallel to the central plane of the movement), typically resulting in the variations between in particular HH and HB, which variations are also known as HH-HB error. With the present invention, HH-HB error can be reduced significantly.

In an embodiment, the component is monolithic and/or shaped by means of etching, such as reactive ion etching or deep reactive ion etching, or shaped by means of laser cutting or 3D printing.

In an embodiment, the component is made from silicon, quartz, glass and/or diamond.

The invention also relates to a method of adjusting a movement for a mechanical watch comprising the steps of determining the temperature sensitivity (typically expressed in seconds per day per degree Celsius, s/d/°C) of just the movement for the watch, manufacturing an oscillator of a brittle material, such as silicon, and applying on the oscillator a layer or combination of layers that exerts a stress, e.g. a tensile stress or a compressive stress, on the oscillator to induce a temperature sensitivity in the oscillator that is opposite to that of the movement, and building the oscillator into the movement. The temperature sensitivity of the movement can be determined by measurements on the movement with a temperature insensitive oscillator installed.

In an embodiment, the temperature sensitivity in the oscillator is at least substantially equal to, e.g. differs less than 10%, preferably less than 5%, preferably less than 2% from the temperature sensitivity of the movement for a watch, but opposite in sign. E.g., the movement has a determined temperature sensitivity of 2,0 s/d/°C and the temperature sensitivity of the oscillator is adjusted, by applying one or more layers as described above, to a value in a range from -1,9 to -2,1 s/d/°C. After building the oscillator into movement, the completed movement is substantially temperature insensitive, at least at temperatures between 15 and 30 °C.

An embodiment comprises the step of determining the temperature sensitivity of the movement in at least two positions and applying on the oscillator a layer that exerts a stress on the oscillator to induce a temperature sensitivity in the oscillator that is opposite to that of the movement in these at least two positions.

The invention further relates to a movement for a watch comprising a base, typically a base plate or pillar plate, an energy storage, typically a mainspring, in particular a spiral spring in a geared barrel, a gear train to transmit torque and energy from the energy storage to an escape wheel, an oscillator, and anchor teeth on an anchor or on the oscillator, which anchor teeth are controlled by the oscillator to alternately block and release the teeth of the escape wheel, and wherein at least one of: the wheels in the gear train, the escape wheel, the anchor, and the oscillator, is a component as discussed above.

In an embodiment, the escape wheel has a torque of less than 2500 nanoNewtonmeter (nNm), preferably less than 2200 nNm, preferably less than 300 nNm, preferably less than 200 nNm, preferably less than 150 nNm and/or the oscillator has and/or the anchor teeth have an amplitude in a range from 3° to 300°, preferably from 3° to 200°, preferably from 3° to 100°, preferably smaller than 30°, preferably smaller than 20°, preferably smaller than 15°, e.g. in range from 3° to 10°, and/or the oscillator has a natural frequency of 3 Hertz (Hz) or higher, preferably 4 Hz or higher, preferably 10 Hz or higher, preferably 25 Hz or higher, preferably 35 Hz or higher. In extreme instances, natural frequencies could be up to 100 Hz or even higher.

The component, such as an geared wheel, escape wheel, anchor, or oscillator may have a thickness smaller than 700 µm, preferably smaller than 550 pm, preferably in a range from 50 µm to 500 pm, preferably in a range from 100 µm to 300 µm.

It is preferred that the oscillator and the anchor teeth are monolithic, i.e. made from a single piece.

The invention also relates to a wristwatch comprising a component or movement as described above.

WO 2019/156552 relates to a mechanical watch oscillator comprising a platform and at least two vibratory masses that are individually suspended on the platform with at least one flexural member. When the masses are vibrating, extensions (reference signs 51, 52 in the drawings of WO 2019/156552) of these masses alternatively release and block an escape wheel, allowing the escape wheel to rotate in steps.

Below, the invention will be explained further, which reference to the appended figures in which an embodiment of the invention is shown.
Figures 1 and 2 are a perspective view and a top plan view of an oscillator and escape wheel according to the present invention.
Figure 3A to 3C are schematic cross-sections of a flexure of an oscillator according to the prior art.
Figure 4A to 4C are schematic cross-sections of a flexure of an oscillator according to the present invention.

Elements in different embodiments that are similar or identical or that perform a similar or identical function are referred to by the same reference number.

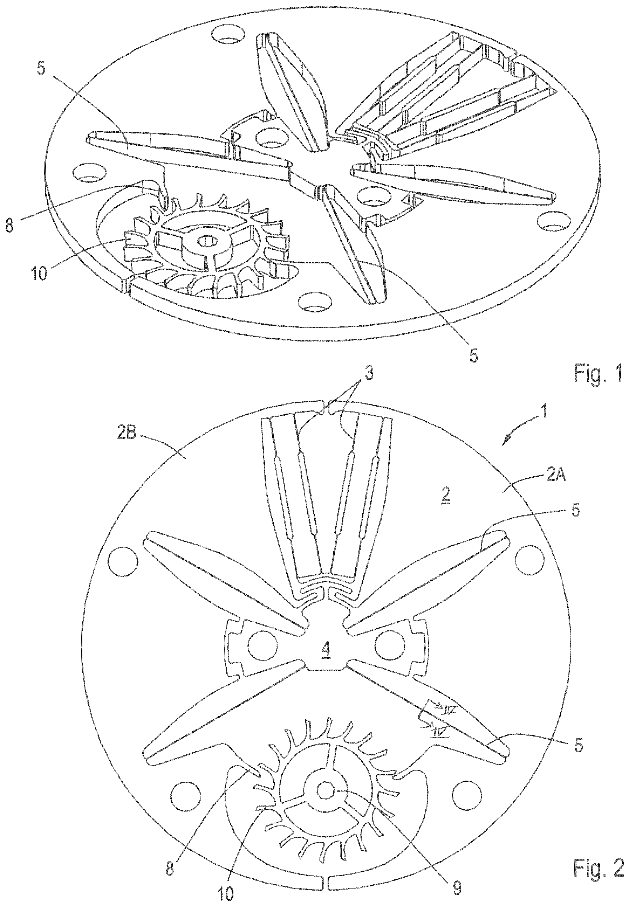

Figures 1 and 2 show a monolithic oscillator 1 for a movement (not shown) for a watch comprising a substantially disc-shaped mass 2 that comprises two halves 2A, 2B that are compliantly interconnected by a set of flexures 3. Each of the halves is connected to a ground 4 by means of a plurality of further flexures, i.c. two radially extending flexures 5, four flexures in total, enabling the mass to oscillate. In the present example, the oscillator has a natural frequency in a range from 20 to 100 Hz, e.g. 40 Hz, and an amplitude in a range from 3° to 10° (in each direction, i.e. both in the CW direction and in the CCW direction), e.g. 5°.

Each of the halves 2A, 2B is provided with an anchor tooth 8, traditionally known as pallet. Further, the halves define an aperture that accommodates an escapement wheel 9 comprising a plurality of teeth 10. During oscillation, the anchor teeth on the oscillator alternately block and release the teeth of the escape wheel.

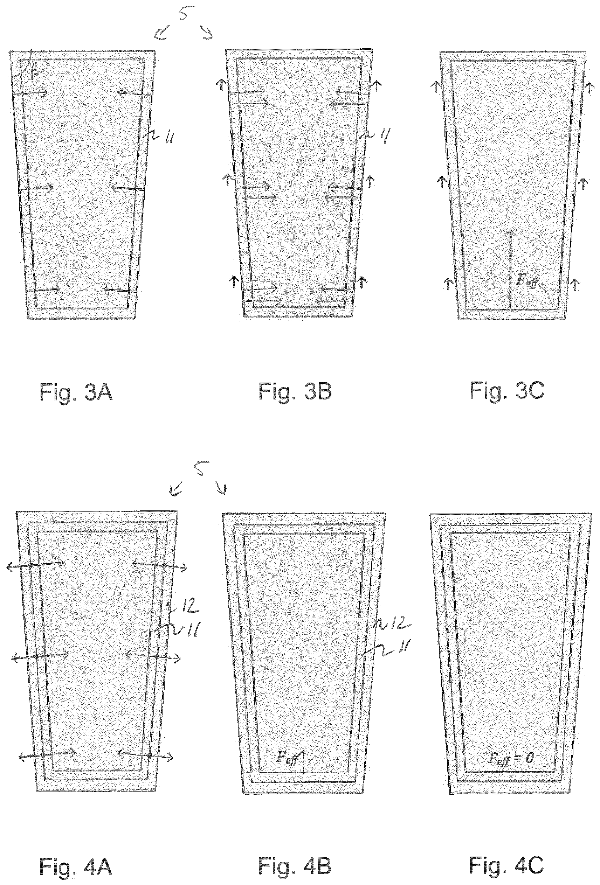

Figures 3A to 3C show a cross-section of one of the flexures 5, the sides of which extend at a slight inclination, e.g. at an angle β of 89,6° with the top surface of the oscillator, as a result of top-side etching using a Bosch or other DRIE process.

The cross-section also shows a layer 11, known in itself, of silicon dioxide having a thickness of 100 nm to improve wear resistance and/or prevent scratches or other damage. The layer exerts a compressive stress on the silicon flexure, illustrated in Figure 3A, resulting, due to the tapering side walls, in a substantial resultant force, F_{eff}, illustrated in Figures 3B and 3C, that in turn results in a substantial HH-HB error.

Figures 4A to 4C show the same cross-section of one of the flexures 5, but with a further layer 12 added, e.g. layer of silicon nitride having a thickness of 360 nm. This additional layer exerts a tensile force on the silicon dioxide layer 11 and the flexure which, as illustrated in Figures 4A and 4B, at least partially annuls the compressive stress in the first layer 11, yielding a much smaller resultant force, F_{eff} (Figure 4B), that in turn results in a much smaller HH-HB error.

In principle, the layers 11, 12 can be adjusted to achieve zero resultant force, F_{eff} = 0, as illustrated in Figure 4C.

The invention is not limited to the described embodiments and can be varied within the scope of the claims.

## Claims

1. Component, such as an oscillator (1), for a movement for a watch, made from a brittle material and comprising a layer (11) covering at least part of the component (1), **characterised in that** the layer (11) exerts a stress on the brittle material it covers **and in that** at least part of the layer (11) is covered with a further layer (12) that exerts an opposite stress.

2. Component (1) according to claim 1, wherein the resultant stress of the layers (11, 12) of opposite is less than 10%, preferably less than 5%, preferably less than 2%, of the stress exerted by the first layer alone.

3. Component (1) according to claim 1 or 2, wherein the thickness of the layers is in a range from 30 nanometers (nm) to 20 micrometers (pm), preferably in a range from 50 nm to 10 µm.

4. Component (1) according to any one of the preceding claims, wherein the material forming a layer (11) exerting a compressive stress is selected from the group comprising silicon oxides, in particular SiO2, silicon nitride, aluminium nitride, titanium nitride, diamond, and polysilicon and/or wherein the material forming a layer (12) exerting tensile stress is selected from the group comprising silicon nitride, silicon carbide, aluminium nitride, aluminium oxide, aluminium, and polysilicon.

5. Component (1) according to any one of the preceding claims, wherein the stress exerted by the layers is in a range from 50 MegaPascal (MPa) to 2 GigaPascal (GPa), preferably 100 MPa to 1.5 GPa.

6. Component (1) according to any one of the preceding claims, wherein the (total) thickness of the compressive layer(s) (11) multiplied by the compressive stress exerted by this layer (11) is substantially equal to the (total) thickness of the tensile layer(s) (12) multiplied by the tensile stress.

7. Component (1) according to any one of the preceding claims, comprising one or more parts having, in cross-section, one or more inclined walls and wherein at least one of the parts is provided with the first and further layers (11, 12).

8. Component (1) according to any one of the preceding claims, wherein the component (1) is monolithic and/or shaped by means of etching, such as reactive ion etching or deep reactive ion etching, laser cutting, 3D printing.

9. Component according to any one of the preceding claims, wherein the component (1) is made from silicon, quartz, glass and/or diamond.

10. Method of adjusting a mechanical watch comprising the steps of determining the temperature sensitivity of the movement of a watch, manufacturing an oscillator (1) of a brittle material and applying on the oscillator a layer (11) that exerts a stress on the oscillator (1) to induce a temperature sensitivity in the oscillator (1) that is opposite to that of the movement, and building the oscillator (1) into the movement.

11. Method according to claim 10, comprising the step of determining the temperature sensitivity of the movement of the watch in at least two positions and applying on the oscillator (1) a layer (11) that exerts a stress on the oscillator (1) to induce a temperature sensitivity in the oscillator (1) that is opposite to that of the movement in these at least two positions.

12. Method according to claim 10 or 11, wherein the temperature sensitivity in the oscillator (1) is adjusted to a value at least substantially equal to the temperature sensitivity of the movement, but opposite in sign.

13. Movement for a watch comprising a base, an energy storage, a gear train to transmit torque and energy from the energy storage to an escape wheel (9), an oscillator (1), and anchor teeth (8) on an anchor or on the oscillator (1), which anchor teeth (8) are controlled by the oscillator (1) to alternately block and release the teeth (10) of the escape wheel (9), and wherein at least one of: the wheels in the gear train, the escape wheel (9), the anchor (8), and the oscillator (1), is a component part according to any one of the preceding claims.

14. Movement according to claim 13, wherein the escape wheel (9) has a torque of less than 2500 nanoNewtonmeter (nNm), preferably less than 2200 nNm, preferably less than 300 nNm, preferably less than 200 nNm, preferably less than 150 nNm and/or the oscillator has and/or the anchor teeth have an amplitude in a range from 3° to 300°, preferably from 3° to 200°, preferably from 3° to 100°, preferably smaller than 30°, preferably smaller than 20°, preferably smaller than 15°, and/or the oscillator has a natural frequency of 3 Hertz (Hz) or higher, preferably 4 Hz or higher, preferably 10 Hz or higher, preferably 25 Hz or higher, preferably 35 Hz or higher.

15. Wristwatch comprising a movement according to claim 13 or 14.
